# EUROPÄISCHE PATENTSCHRIFT

(11) **EP 1 111 021 B1**
(45) Veröffentlichungstag und Bekanntmachung des Hinweises auf die Patenterteilung: **23.03.2005**
(21) Anmeldenummer: 00124718.8
(22) Anmeldetag: 13.11.2000
(51) Int. Cl.: C09J 7/02

(54) **Doppelseitiges Klebeband**
Double-sided adhesive tape
Ruban adhésif double face

(30) Priorität: 24.12.1999 DE 29922805 U
(43) Veröffentlichungstag der Anmeldung: 27.06.2001
(73) Patentinhaber: Coroplast Fritz Müller GmbH & Co. K.G., 42279 Wuppertal (DE)
(72) Erfinder: Lodde, Christoph, 44225 Dortmund (DE)
(74) Vertreter: Patentanwälte Dr. Solf & Zapf

(56) Entgegenhaltungen:
- EP-A- 0 320 676
- EP-A- 0 806 464
- WO-A-95/13184
- WO-A-99/38930

## Beschreibung

Die vorliegende Erfindung betrifft ein doppelseitiges Klebeband nach dem Oberbegriff des Anspruchs 1. Des Weiteren betrifft die Erfindung eine Verwendung eines doppelseitigen Klebebandes nach dem Oberbegriff des Anspruchs 9.

Bisher werden aus einzelnen isolierten elektrischen Adern bebündelte Kabelsätze, z.B. in Automobilbau, eingesetzt, die insbesondere mit Clipsen oder mittels einer Kleberschicht aus einem Hotmeltkleber an der Karosserie befestigt werden. Auch ist es bereits bekannt, flexible Leiterbahnen als sogenannte FPC-Leitungen (FPC = Flexible Printed Circuit) anstelle von gebündelten Kabelsätzen zu verwenden. Bei derartigen extrem flachen Leitungen ist der Einsatz von mechanischen Befestigungsmitteln nicht zweckmäßig. Insbesondere können die mechanischen Befestigungsmittel die auf dem FPC-Leitungen befindlichen elektrischen Leiterbahnen beschädigen. Es wäre deshalb ein anderes Layout der auf den FPC-Leitungen befindlichen Leiterbahnen erforderlich, um den Leiterbahnverlauf an das Befestigungssystem anzupassen. Hierdurch entstünde aber ein beträchtlicher Herstellungsaufwand.

Ein Klebeband der eingangs genannten Art ist aus der EP-A-0 320 676 bekannt. Dieses Dokument betrifft einen polymerfolienbeschichteten Schaumstoff, bei dem die Folienbeschichtung durch Auftragen des bevorzugt aus Polyalkylenen (insbesondere LDPE, HDPE oder LLDPE) bestehenden Folienmaterials aus der Schmelze auf die Schaumstoffschicht aufgebracht ist. Dabei wird ausgeführt, daß sich die beschriebenen Schaumstoffe aus Polyolefinen, Polyethylenvinylacetatcopolymeren, Polyurethan, Neopren, Silicon oder Polyvinylchlorid bevorzugt zur Herstellung von verhauteten Dämpfungs- und Isolationsschäumen oder Akustikschäumen oder auch als Montageklebebänder einsetzen lassen. Für Montageklebebänder werden dabei als Haftkleber im Wesentlichen alle bekannten Kleber, wie aus Natur- oder Synthesekautschuk, aus Polysiloxan oder Polyacrylat bestehende Kleber, als geeignet angesehen. Bei Verwendung eines Klebebandes der beschriebenen Art kann dessen polymerfolienbeschichtete Seite unter Druck und Wärme aus ein EPDM-Profil laminiert werden und das derart gebildete Gummiprofil nach Abziehen eines auf dem Haftkleber befindlichen Schutzpapiers verklebt werden.

Ein ähnliches Klebeband, das unter Verwendung zweier unterschiedlicher Kleber, wie eines Hotmelt-Klebers und eines Haftklebers hergestellt ist, offenbart auch die WO-A-99 389 30. Sowohl in diesem Dokument als auch in dem vorgenannten sind die für eine Auftragung auf den Klebebandträger in Frage kommenden Kleber hinsichtlich ihrer thermischen Eigenschaften nicht spezifiziert.

Der vorliegenden Erfindung liegt die Aufgabe zu Grunde, ein Befestigungsmittel zur Verfügung zu stellen, mit dem FPC-Leitungen schnell, sicher, kostengünstig und platzsparend an einem Untergrund befestigt werden können, wobei eine lange Haltbarkeit gewährleistet ist. Des Weiteren liegt der Erfindung die Aufgabe zu Grunde, eine neue Verwendung eines doppelseitigen Klebebandes der eingangs genannten Art zu erschließen.

Erfindungsgemäß wird dies bei einem doppelseitigen Klebeband der eingangs genannten Art dadurch erreicht, daß der Hotmeltkleber einen Schmelzpunkt von ca. 150°C bis 180°C aufweist und der druckempfindliche Haftkleber aus einem vernetzten Acrylatkleber besteht, der eine kurzzeitige Temperaturbeständigkeit für Temperaturbelastungen von 180°C bis 200°C aufweist, die derart auf den Schmelzpunkt des Hotmeltklebers abgestimmt ist, daß der Haftkleber bei einem Aufschmelzen des Hotmeltklebers, bei dem die Wärmeeintragung durch den Haftkleber hindurch erfolgt, nicht zerstört wird.

Die Erfindung bezieht sich, was ihren Verwendungsaspekt betrifft, darauf, ein doppelseitigen Klebebandes, bestehend aus einem bandförmigen Träger und beidseitig auf dem Träger angeordneten Kleberschichten, wobei die erste Kleberschicht aus einem Hotmeltkleber und die zweite Kleberschicht aus einem druckempfindlichen Acrylat-Haftkleber besteht, zum Befestigen von FPC-Leitungen einzusetzen, wobei die erste Kleberschicht zum Befestigen auf einem Untergrund, wie einem Metallkarosserieteil oder einem Dachhimmel eines Automobils, und die zweite Kleberschicht zum Befestigen einer FPC-Schaltung am Klebeband dient und wobei der Hotmeltkleber einen Schmelzpunkt von ca. 150°C bis 180°C aufweist und der druckempfindliche Haftkleber ein vernetzter Acrylat-Haftkleber ist, der eine kurzzeitige Temperaturbeständigkeit für Temperaturbelastungen von 180°C bis 200°C derart aufweist, daß er bei einem Aufschmelzen des Hotmeltklebers, nicht zerstört wird.

Erfindungsgemäß wird somit ein Hybrid-Klebersystem geschaffen, mit dem FPC-Leitungen im Automobilbau schnell und rationell an der Karosserie, an dem Türmodul oder dem Dachhimmelmodul befestigt werden können. Hierbei wird das erfindungsgemäße Klebeband mit seiner ersten Kleberschicht mit Hilfe eines Heizstiftes oder Bügeleisens auf dem Untergrund aufgeschmolzen, d.h. z.B. aufgebügelt, wobei das Aufschmelzen unter einer gewissen Druckausübung erfolgt. Hierdurch kann das erfindungsgemäße Klebeband mit dem Karosserieblech oder am Dachhimmel einfach und schnell fixiert werden. Danach wird ein auf der aus dem Druckhaftkleber bestehende Kleberschicht befindliches Abdeckmaterial, z.B. ein silikonisiertes Abdeckpapier entfernt und die FPC-Leitung kann nun leicht aufgeklebt werden. Das Abdeckmaterial dient einerseits zum Schutz der zweiten Kleberschicht beim Aufbügeln und andererseits auch zum Schutz der Haftkleberschicht gegen Verkleben mit der Heißsiegelschicht im aufgerollten Zustand des erfindungsgemäßen doppelseitigen Klebebandes, das in Rollenform transportiert und gelagert wird.

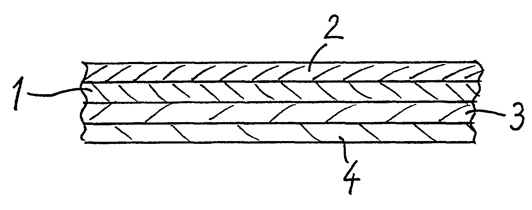

In den Unteransprüchen sind vorteilhafte Ausgestaltungen der Erfindung enthalten. Anhand des in der beiliegenden Zeichnung dargestellten Ausführungsbeispiels wird die Erfindung näher erläutert.

Ein erfindungsgemäßes doppelseitiges Klebeband besteht aus einem Träger 1, der auf jeder seiner beiden Seiten eine Kleberschicht 2, 3 aufweist. Die erste Kleberschicht 2 besteht vorzugsweise aus einem Hotmeltkleber auf der Basis eines amorphen Polyalphaolefins (APAO). Durch die Verwendung dieses Materials ist eine Dauertemperaturstandfestigkeit von ca. 105°C gewährleistet. Es sollte vorzugsweise eine APAO-Polymer mit einem Schmelzpunkt von 150°C bis 180°C gewählt werden. Um die Verklebung mit unterschiedlichen Untergründen zu optimieren, kann dieses APAO-Polymer mit Harzen, Weichmachern und/oder Füllstoffen vermischt werden. Das Flächengewicht der ersten Kleberschicht 2 sollte ca. 50 Gramm/m² bis 150 Gramm/m² betragen. Diese erste Kleberschicht 2 dient zur Verklebung des erfindungsgemäßen Klebebandes mit einem Untergrund, wobei es sich beispielsweise um ein Metallkarosserieteil oder aber um einen Dachhimmel eines Automobils handeln kann. Der Träger 1 besteht vorzugsweise aus einer PET-Folie (Polyethylenterephtalat). Diese Materialauswahl gewährleistet, daß beim Aufschmelzen der aus dem Hotmeltkleber bestehenden ersten Kleberschicht 2 der Träger 1 selbst nicht aufschmilzt. Der Träger 1 kann z.B. eine Folienstärke von 0,012 mm bis 0,048 mm besitzen.

Die zweite Kleberschicht 3, die zum Befestigen einer nicht dargestellten FPC-Leitung am Klebeband und mittels dieses Klebebandes an einem Untergrund dient, besteht aus einem druckempfindlichen Haftkleber, mit einer kurzzeitigen Temperaturbeständigkeit für Temperaturbelastungen von ca. 180°C bis 200°C. Hierbei handelt es sich vorzugsweise um einen vernetzten Acrylatkleber. Der Vorteil dieses Klebers ist, daß er kurzfristig Temperaturen von ca. 200°C standhält. Durch die kurzzeitige Temperaturbeständigkeit des vernetzten Acrylatklebers wird gewährleistet, daß er durch die Temperaturbelastung beim Aufschmelzen des Hotmeltklebers und der dadurch erreichten Fixierung des Klebebandes, beispielsweise mit Hilfe eines Heizstiftes oder Bügeleisens nicht zerstört wird. Die zweite Kleberschicht 3 hat vorteilhafterweise ein Flächengewicht von 60 Gramm/m² bis 100 Gramm/m².

Um die Kleberschichten 2, 3 von einander zu trennen, wenn sich das erfindungsgemäße Klebeband im aufgerollten Zustand befindet und auch eine Beschädigung der zweiten Kleberschicht 3 beim Aufbügeln des erfindungsgemäßen Klebebandes zu verhindern, ist die zweite Kleberschicht 3 mit einem bei der Aufschmelztemperatur der Kleberschicht 2 temperaturbeständigen Abdeckmaterial 4 abgedeckt. Bei diesem Abdeckmaterial, das als Interliner bekannt ist, kann es sich beispielsweise um ein doppelseitig silikonisiertes Papier oder eine doppelseitig silikonisierte Polyesterfolie handeln. Diese Materialien haben die Eigenschaft, daß sie beim Aufschmelzprozeß des die Kleberschicht 2 bildenden Hotmeltklebers nicht beschädigt werden, da sie ausreichend temperaturbeständig sind. Das verwendete Papier kann beispielsweise ein Flächengewicht von 40 Gramm/m² bis 90 Gramm/m² besitzen.

Folgendes Ausführungsbeispiel hat sich als vorteilhaft erwiesen:

| | |
|---|---|
| Kleberschicht 2 | Hotmeltkleber auf der Basis von APAO-Polymer mit einem Flächengewicht von 100 Gramm/m ² , |
| | |
| Material des Trägers 1 | PET-Folie mit einer Dicke von 0,036 mm, |
| | |
| Kleberschicht 3 | vernetzter Acrylatkleber mit einem Flächengewicht von 60 Gramm/m ² , |
| | |
| Interliner 4 | beidseitig silikonisiertes Papier. |

Mit dem erfindungsgemäßen doppelseitigen Klebeband wird ein preiswertes und sehr wirksames Befestigungsmittel für FPC-Leitungen zur Verfügung gestellt. Die FPC-Leitungen können mit dem erfindungsgemäßen Klebeband vollflächig verklebt werden. Es kann aber unter Umständen auch eine partielle Verklebung ausreichen.

## Patentansprüche

1. Doppelseitiges Klebeband, insbesondere zum Befestigen von FPC-Leitungen (Flexible-Printed-Circuit-Leitungen) in Automobilaufbauten, bestehend aus einem bandförmigen Träger (1) und beidseitig auf dem Träger (1) angeordneten Kleberschichten (2, 3), wobei die erste Kleberschicht (2), die zum Befestigen am Untergrund dient, aus einem Hotmeltkleber besteht und die zweite Kleberschicht (3), die insbesondere zum Befestigen der FPC-Schaltung am Klebeband dient, aus einem druckempfindlichen Acrylat-Haftkleber besteht,
**dadurch gekennzeichnet, daß** der Hotmeltkleber einen Schmelzpunkt von ca. 150°C bis 180°C aufweist und der druckempfindliche Haftkleber aus einem vernetzten Acrylatkleber besteht, der eine kurzzeitige Temperaturbeständigkeit für Temperaturbelastungen von 180°C bis 200°C aufweist, die derart auf den Schmelzpunkt des Hotmeltklebers abgestimmt ist, daß der Haftkleber bei einem Aufschmelzen des Hotmeltklebers, bei dem die Wärmeeintragung durch den Haftkleber hindurch erfolgt, nicht zerstört wird.

2. Klebeband nach Anspruch 1,
**dadurch gekennzeichnet, daß** der Träger (1) aus einer PET-Folie besteht, mit einer Folienstärke von insbesondere 0,01 mm bis 0,048 mm.

3. Klebeband nach Anspruch 1 oder 2,
**dadurch gekennzeichnet, daß** das Material des Hotmeltklebers der ersten Kleberschicht (2) auf der Basis von einer amorphen Polyalphaolefins (APAO) hergestellt ist, vorzugsweise einem Polyalphaolefin-Polymer mit einem Schmelzpunkt von 150°C bis 180°C.

4. Klebeband nach Anspruch 3,
**dadurch gekennzeichnet, daß** das Hotmeltklebermaterial mit Harzen, Weichmachern und/oder Füllstoffen vermischt ist.

5. Klebeband nach einem der Ansprüche 1 bis 4,
**dadurch gekennzeichnet, daß** die erste Kleberschicht (2) ein Flächengewicht von 50 Gramm/m² bis 150 Gramm/m² besitzt.

6. Klebeband nach einem der Ansprüche 1 bis 5,
**dadurch gekennzeichnet, daß** die zweite Kleberschicht (3) ein Flächengewicht von ca. 60 Gramm/m² bis 100 Gramm/m² aufweist.

7. Klebeband nach einem der Ansprüche 1 bis 6,
**dadurch gekennzeichnet, daß** auf der Außenseite der zweiten Kleberschicht (3) ein bei der Aufschmelztemperatur der ersten Kleberschicht (2) temperaturbeständiges Abdeckmaterial (4) aufgebracht ist, das vorzugsweise aus einer beidseitig silikonisierten Polyesterfolie oder einem beidseitig silikonisierten Papier besteht.

8. Klebeband nach Anspruch 7,
**dadurch gekennzeichnet, daß** das Papierband ein Flächengewicht von 40 Gramm/m² bis 90 Gramm/m² aufweist.

9. Verwendung eines doppelseitigen Klebebandes, gemäß den Ansprüchen 1-8 zum Befestigen von FPC-Leitungen (Flexible-Printed-Circuit-Leitungen), insbesondere in Automobilaufbauten, wobei die erste Kleberschicht (2) zum Befestigen auf einem Untergrund, wie einem Metallkarosserieteil oder einem Dachhimmel eines Automobils, und die zweite Kleberschicht (3) zum Befestigen einer FPC-Schaltung (Flexible-Printed-Circuit-Schaltung) am Klebeband dient.

## Claims

1. Double-sided adhesive tape, particularly for fixing FPC lines (flexible printed circuit lines) in car bodies, composed of a tape-shaped carrier (1) and adhesive layers (2, 3) deposed on either side of the carrier (1), the first adhesive layer (2), intended for fixing on the substrate, being composed of a hotmelt adhesive and the second adhesive layer (3), intended especially for fixing the FPC on the adhesive tape, being composed of a pressure-sensitive acrylate adhesive, **characterized in that** the hotmelt adhesive has a melting point of from about 150°C to 180°C and the pressure-sensitive adhesive is composed of a crosslinked acrylate adhesive which has a short-term temperature stability for temperature loads of from 180°C to 200°C, which is harmonized with the melting point of the hotmelt adhesive in such a way that when the hotmelt adhesive is melted by heat introduced through the pressure-sensitive adhesive the pressure-sensitive adhesive is not destroyed.

2. Adhesive tape according to Claim 1, **characterized in that** the carrier (1) is composed of a PET film having a thickness of in particular from 0.01 mm to 0.048 mm.

3. Adhesive tape according to Claim 1 or 2, **characterized in that** the material of the hotmelt adhesive of the first adhesive layer (2) has been prepared on the basis of an amorphous poly-alpha-olefin (APAO), preferably a poly-alpha-olefin polymer having a melting point of from 150°C to 180°C.

4. Adhesive tape according to Claim 3, **characterized in that** the hotmelt adhesive material has been blended with resins, plasticizers and/or fillers.

5. Adhesive tape according to any one of Claims 1 to 4, **characterized in that** the first adhesive layer (2) possesses a weight per unit area of from 50 grams/m² to 150 grams/m².

6. Adhesive tape according to any one of Claims 1 to 5, **characterized in that** the second adhesive layer (3) possesses a weight per unit area of from about 60 grams/m² to 100 grams/m².

7. Adhesive tape according to any one of Claims 1 to 6, **characterized in that** on the outside of the second adhesive layer (3) a liner material (4) has been applied which is temperature-stable at the melting temperature of the first adhesive layer (2) and is composed preferably of a double-sidedly siliconized polyester film or a double-sidedly siliconized paper.

8. Adhesive tape according to Claim 7, **characterized in that** the paper tape has a basis weight of from 40 grams/m² to 90 grams/m².

9. Use of a double-sided adhesive tape according to Claims 1 - 8 for fixing FPC lines (flexible printed circuit lines), particularly in car bodies, the first adhesive layer (2) being intended for fixing on a substrate, such as a metal bodywork part or the roof lining of a car, and the second adhesive layer (3) being intended for fixing an FPC on the adhesive tape.

## Revendications

1. Ruban adhésif double face, destiné en particulier à la fixation de canalisations de FPC (canalisations Flexible-Printed-Circuit) dans des carrosseries automobiles, composé d'un support (1) en forme de ruban et de couches de colles (2, 3), disposées sur les deux faces du support (1) la première couche de colle (2) destinée à la fixation sur la base étant composée d'une colle thermofusible et la seconde couche de colle (3) destinée notamment à fixer le circuit FPC sur le ruban adhésif étant composée d'un adhésif de contact d'acrylate sensible à la pression,
**caractérisé en ce que** la colle thermofusible a un point de fusion d'environ 150°C à 180°C et **en ce que** l'adhésif d'acrylate est constitué d'un acrylate réticulé présentant une courte résistance thermique aux charges thermiques comprises entre 180°C et 200°C, qui est adapté au point de fusion de la colle thermofusible, de façon à ce que l'adhésif de contact ne soit pas détruit lors de la fusion de la colle thermofusible, au cours de laquelle la chaleur est introduite par l'intermédiaire de la colle thermofusible.

2. Ruban adhésif selon la revendication 1,
**caractérisé en ce que** le support (1) est fait d'un film de PET possédant en particulier une épaisseur de film de 0,01mm à 0,048mm.

3. Ruban adhésif selon la revendication 1 ou 2,
**caractérisé en ce que** la matière de la colle thermofusible de la première couche de colle (2) est fabriquée sur la base d'une polyalphaoléfine (APAO), de préférence d'un polymère de polyalphaoléfine ayant un point de fusion à 150 °C à 180°C.

4. Ruban adhésif selon la revendication 3 ,
**caractérisé en ce que** la matière de la colle thermofusible est mélangée avec des résines et des plastifiants et/ou des charges.

5. Ruban adhésif selon l'une quelconque des revendications 1 à 4,
**caractérisé en ce que** la première couche de colle (2) a un grammage de 50 g/m² à 150 g/m².

6. Ruban adhésif selon l'une quelconque des revendications 1 à 5,
**caractérisé en ce que** la seconde couche de colle (3) a un grammage d'environ 60 g/m² à 100 g/m².

7. Ruban adhésif selon l'une quelconque des revendications 1 à 6,
**caractérisé en ce qu'**une matière de recouvrement (4) résistant à la température de fusion de la première couche de colle (2) et constituée de préférence d'un film polyester siliconé sur les deux faces ou d'un papier siliconé sur les deux faces est appliquée sur la face extérieure de la seconde couche de colle (3).

8. Ruban adhésif selon la revendication 7,
**caractérisé en ce que** le ruban de papier à un grammage de 40 grammes/m² à 90 grammes/m².

9. Utilisation d'un ruban adhésif double face selon les revendications 1 à 8, pour la fixation de canalisations en FPC (canalisation Flexible-Printed-Circuit), notamment dans des carrosseries automobiles, la première couche de colle (2) servant à la fixation sur une base, comme une pièce de carrosserie métallique ou un pavillon de toit d'une automobile, et la seconde couche de colle (3) servant à la fixation d'un circuit FPC (Flexible-Printed-Circuit).
